# EUROPEAN PATENT APPLICATION

(11) **EP 4 080 555 A1**
(43) Date of publication of application: **26.10.2022**
(21) Application number: 22168162.0
(22) Date of filing: 13.04.2022
(51) Int. Cl.: H01L 21/768, H01L 23/535

(54) **THERMAL BUDGET ENHANCED BURIED POWER RAIL AND METHOD OF MANUFACTURING THE SAME**

(30) Priority: 19.04.2021 US 202163176620 P; 29.06.2021 US 202117361996
(71) Applicant: Samsung Electronics Co., Ltd., Gyeonggi-do, 16677 (KR)
(72) Inventor: PARK, Saehan, Clifton Park, NY 12065 (US); SEO, Hoonseok, Niskayuna, NY 12309 (US); SEO, Kang Ill, Springfield, VA 22152 (US)
(74) Representative: Kuhnen & Wacker Patent- und Rechtsanwaltsbüro PartG mbB

(57) **Abstract**

Provided is a semiconductor architecture including a wafer, a semiconductor device provided on the wafer, the semiconductor device including an epitaxial layer, an epitaxial contact provided on the epitaxial layer, a first via provided on the epitaxial contact, and metal lines provided on the first via, the metal lines being configured to route signals, an oxide layer provided on a first surface of the wafer and adjacent to the semiconductor device, and a buried power rail (BPR) configured to deliver power, at least a portion of the BPR being included inside of the wafer, wherein a portion of the BPR contacts the oxide layer.

## Description

### BACKGROUND

### 1. Field

Example embodiments of the present disclosure relate to a buried power rail (BPR) included in a semiconductor architecture and a method of manufacturing the same, and more particularly to a thermal budget enhanced BPR included in a semiconductor architecture and a method of manufacturing the same.

### 2. Description of Related Art

A semiconductor architecture including a buried power rail (BPR) may reduce resistance and increase routing flexibility in a semiconductor architecture compared to power rails that are formed at a same level as the routing metal layers. A size of the semiconductor architecture including a BPR may be reduced compared to a semiconductor architecture including power rails formed at the routing metal layer level.

A BPR is generally formed in the semiconductor architecture prior to providing the front-end-of-line (FEOL) layer of the semiconductor architecture that includes active devices such as epitaxial layers and gates. A relatively high temperature greater than about 1000 °C is required when forming the FEOL layer in the semiconductor architecture. As a BPR includes a metal material such as, for example, cobalt, tungsten, or ruthenium, the BPR may be degraded by metal migration or diffusion occurring when the FEOL layer is formed at a high temperature. Such metal migration or diffusion of the BPR may cause tool contamination and increase leakage which may lead to a device degradation or failure.

Information disclosed in this Background section has already been known to the inventors before achieving the embodiments of the present application or is technical information acquired in the process of achieving the embodiments. Therefore, it may contain information that does not form the prior art that is already known to the public.

### SUMMARY

One or more example embodiments provide a semiconductor architecture including a buried power rail and a method of manufacturing the same.

One or more example embodiments also provide a thermal budget enhanced buried power rail of a semiconductor architecture and a method of manufacturing the same.

According to an aspect of an example embodiment, there is provided a semiconductor architecture including a wafer, a semiconductor device provided on the wafer, the semiconductor device including an epitaxial layer, an epitaxial contact provided on the epitaxial layer, a first via provided on the epitaxial contact, and metal lines provided on the first via, and the metal lines being configured to route signals, an oxide layer provided on a first surface of the wafer and adjacent to the semiconductor device, and a buried power rail (BPR) configured to deliver power, at least a portion of the BPR being included inside of the wafer, wherein a portion of the BPR contacts the oxide layer.

According to another aspect of an example embodiment, there is provided a method of manufacturing a semiconductor architecture, the method including providing a wafer, patterning fins on the wafer, providing a front-end-of-line (FEOL) layer on the wafer, etching a trench in the wafer, filling the trench with a metal material to form a buried power rail (BPR), providing a middle-of-line (MOL) layer on the wafer, providing a back-end-of-line (BEOL) layer on the wafer.

According to another example embodiment, there is provided a method of manufacturing a semiconductor architecture, the method including providing a wafer, patterning fins on the wafer, providing a front-end-of-line (FEOL) layer on the wafer and the fins, providing a trench in the wafer to a level lower than the fins in a vertical direction, filling the trench with a metal material to form a buried power rail (BPR) configured to deliver power, providing a middle-of-line (MOL) layer on the wafer that is connected to the BPR, and providing a back-end-of-line (BEOL) layer on the wafer, the BEOL layer being configured to route signals.

### BRIEF DESCRIPTION OF THE DRAWINGS

The above and/or other aspects, features, and advantages of example embodiments of the disclosure will be more apparent from the following description taken in conjunction with the accompanying drawings, in which:
FIG. 1 illustrates a semiconductor architecture including a BPR according to a related embodiment;
FIGS. 2A, 2B, 2C, 2D, 2E, 2F, 2G, and 2H illustrate a method of manufacturing a semiconductor architecture in FIG. 1 including a BPR according to a related embodiment;
FIG. 3 illustrates a perspective view of a semiconductor architecture including a BPR according to an example embodiment;
FIG. 4 illustrates a cross-sectional view taken along line I-I' of FIG. 3 according to an example embodiment;
FIG. 5A, 5B, 5C, 5D, 5E, 5F, 5G, and 5H illustrate a method of manufacturing a semiconductor architecture in FIG. 4 according to an example embodiment;
FIG. 6 illustrates a cross-sectional view taken along line I-I' of FIG. 3 according to another example embodiment;
FIG. 7A, 7B, 7C, 7D, 7E, and 7F illustrate a method of manufacturing a semiconductor architecture in FIG. 6 according to an example embodiment;
FIG. 8 illustrates a flowchart of a method of manufacturing a semiconductor architecture including a BPR according to an example embodiment;
FIG. 9 illustrates a flowchart of a method of manufacturing a semiconductor architecture including a BPR according to another example embodiment;
FIG. 10 illustrates a semiconductor package that may incorporate the semiconductor architecture including a BPR according to example embodiments; and
FIG. 11 illustrates a schematic block diagram of an electronic system that may incorporate the semiconductor architecture including a BPR according to example embodiments.

### DETAILED DESCRIPTION

The example embodiments described herein are examples, and thus, the present disclosure is not limited thereto, and may be realized in various other forms. Each of the example embodiments provided in the following description is not excluded from being associated with one or more features of another example or another example embodiment also provided herein or not provided herein but consistent with the present disclosure. For example, even if matters described in a specific example or example embodiment are not described in a different example or example embodiment thereto, the matters may be understood as being related to or combined with the different example or embodiment, unless otherwise mentioned in descriptions thereof.

In addition, it should be understood that all descriptions of principles, aspects, examples, and example embodiments are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "top," and "bottom," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. Herein, when a term "same" is used to compare a dimension of two or more elements, the term may cover a "substantially same" dimension.

It will be understood that, although the terms "first," "second," "third," "fourth," etc. may be used herein to describe various elements, these elements should not be limited by these terms. These terms are only used to distinguish one element from another element. Thus, a first element discussed below could be termed a second element without departing from the teachings of the present disclosure.

It will be also understood that, even if a certain step or operation of manufacturing an apparatus or structure is described later than another step or operation, the step or operation may be performed later than the other step or operation unless the other step or operation is described as being performed after the step or operation.

Example embodiments are described herein with reference to cross-sectional illustrations that are schematic illustrations of the example embodiments (and intermediate structures). As such, variations from the shapes of the illustrations as a result, for example, of manufacturing techniques and/or tolerances, are to be expected. Thus, the example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present disclosure. Further, in the drawings, the sizes and relative sizes of layers and regions may be exaggerated for clarity.

For the sake of brevity, general elements to semiconductor devices may or may not be described in detail herein.

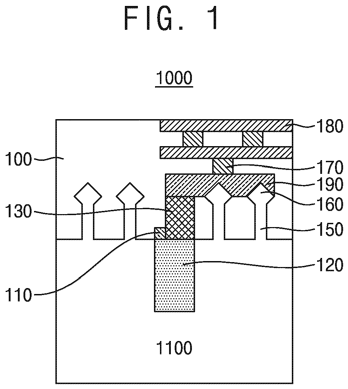

FIG. 1 illustrates a semiconductor architecture including a BPR according to a related art.

According to a related art, the semiconductor architecture 1000 includes a wafer 1100 and fins 150 patterned on the wafer 1100. The wafer 1100 and the fins 150 include, for example, silicon (Si). The fins 150 may be respective channel structures of fin field-effect transistors (FinFETs). The semiconductor architecture 1000 further includes an oxide layer 1101 formed on the wafer 1100, and a semiconductor device formed on the wafer 1100. The semiconductor device may be an integrated circuit configured to, for example, route signals, deliver power and/or operate as a part of a logic gate. For example, the semiconductor device includes epitaxial layers 160 grown on the fins 150. The epitaxial layers 160 may form active regions, i.e., source/drain regions, of the transistors, and may include, for example, Si. The epitaxial layers 160 are included in a front-end-of-line (FEOL) layer formed on the wafer 1100.

In the middle-of-line (MOL) layer of the semiconductor device, an epitaxial contact 190 is formed to contact the epitaxial layers 160, and extends in a horizontal direction parallel to the first surface of the wafer 1100. A vertical contact 130 is formed on a surface of the epitaxial contact 190 and extends in the oxide layer toward a first surface of the wafer 1100. In the back-end-of-line (BEOL) layer of the semiconductor device, metal layers 180 configured to route signals is formed, and vias 170 are formed between the metal layers 180 to interconnect the metal layers 180. Additional vias 170 are formed between the epitaxial contact 190 and a metal layer 180 to connect the signal wiring layer to the epitaxial layers 160.

A buried power rail (BPR) 120 is formed to contact the vertical contact 130 and penetrate into the wafer 1100 to a level below the fins 150 in a vertical direction. The BPR is configured to deliver power.

The epitaxial layers 160 includes a power tapping epitaxial layer and a non-power tapping epitaxial layer. The metal layers 180 are connected to the non-power tapping epitaxial layer of the epitaxial layers 160 for internal signal routing. The BPR 120 is connected to the power tapping epitaxial layer of the epitaxial layers 160. The BPR 120 is configured to deliver power to the epitaxial layers 160, that is active regions.

According to the related art, the semiconductor architecture 1000 may also include a portion of a BPR capping layer 110 that is formed on an exposed surface of the BPR 120. The BPR capping layer 110 includes a dielectric material such as, for example, silicon nitride (SiN).

According to the related art, the BPR 120 may be thermally degraded by metal migration or diffusion, and the resistance of the BPR 120 may become relatively high which may lead to a degradation of the semiconductor device or a failure in the semiconductor device.

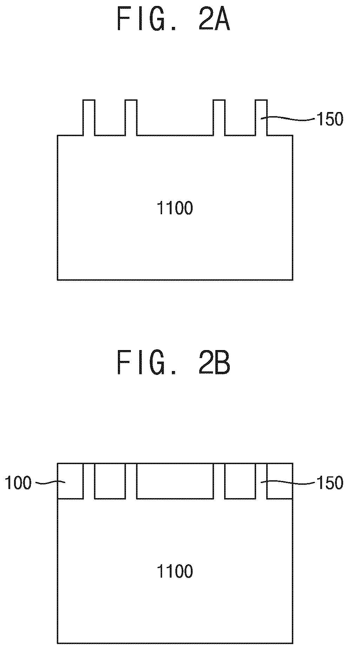

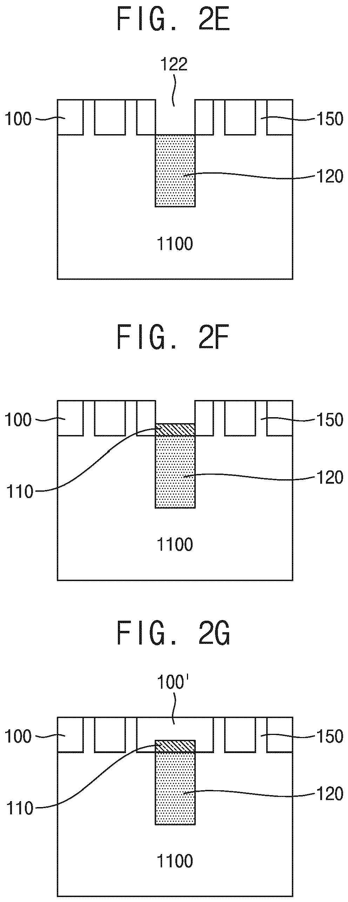

FIGS. 2A through 2H illustrate a method of manufacturing a semiconductor architecture in FIG. 1 according to a related art.

As illustrated in FIGS. 2A and 2B, the method includes providing a wafer 1100. The wafer 1100 includes, for example, Si.

The method includes patterning fins 150 on the wafer 1100 and forming an oxide layer 1101 on the wafer 1100. The fins 150 include, for example, Si, and form respective channel structures of FinFETs.

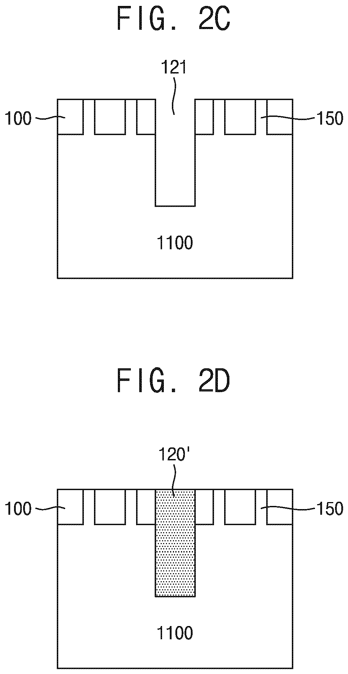

As illustrated in FIG. 2C, a trench 121 is formed in the oxide layer 1101 and the wafer 1100 to a level below the fins 150 in a vertical direction. Referring to FIG. 2D, the trench 121 is filled with a metal material 120' such as, for example, cobalt (Co), tungsten (W), and ruthenium (Ru).

As illustrated in FIGS. 2E to FIG. 2G, the metal material 120' is etched to a level of a first surface of the wafer 1100 to form a BPR 120. A BPR capping layer 110 is formed on the exposed surface of the BPR 120 to insulate the BPR 120. The BPR capping layer 110 includes, for example, silicon nitride (SiN). The space formed by etching the BPR 120 above the BPR capping layer 110 is filled with oxide material 100'. The oxide layer 1101 and the oxide material 100' maybe integrally formed.

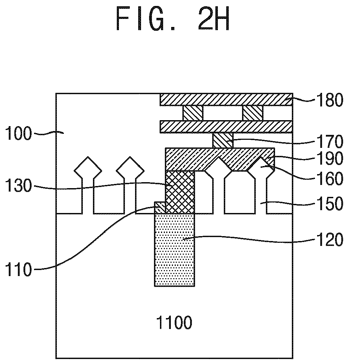

As illustrated in FIG. 2H, a semiconductor device is formed on the wafer 1100. Forming the semiconductor device includes forming an FEOL layer including epitaxial layers 160 that are formed on the fins 150. An MOL layer is formed on the FEOL layer. The MOL layer includes an epitaxial contact 190 that contacts the epitaxial layers 160 and extends in a horizontal direction, and a vertical contact 130 that contacts the epitaxial contact 190 and the BPR 120. A BEOL layer is formed on the MOL layer. The BEOL layer includes metal layers 180 and vias 170 formed between the metal layers 180 to interconnect the metal layers 180. Another via 170 may be also formed between the epitaxial contact 190 and a metal layer 180 to connect the epitaxial layers 160 to the metal layer 180. Oxide material that is integrally formed with the oxide layer 10 may be adjacent to the FEOL layer, the MOL layer, and the BEOL layer to a level of the BEOL layer in a vertical direction.

According to the related art, the BPR 120 is formed before the FEOL layer is formed. As forming the FEOL layer requires high temperature that is greater than about 1000 °C, the BPR 120 may be thermally degraded during the formation of the FEOL layer. For example, metal migration or diffusion may occur in the BPR 120. The metal migration or diffusion may result in the resistance of the BPR 120 increasing, which may degrade the performance of the semiconductor device or lead to a failure in the semiconductor device.

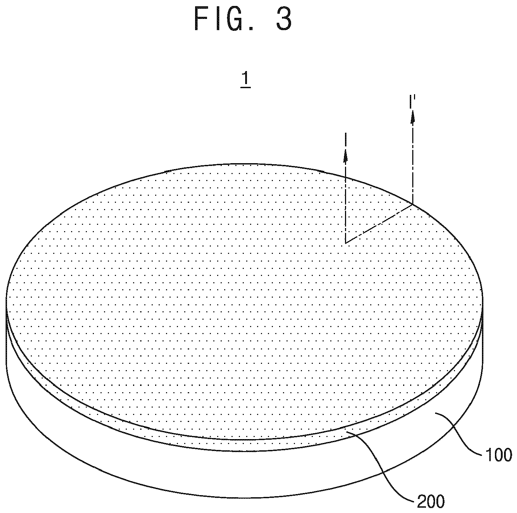

FIG. 3 illustrates a perspective view of a semiconductor architecture including a BPR according to an example embodiment.

As illustrated in FIG. 3, the semiconductor architecture 1 includes a wafer 100 and a semiconductor device 200 formed on a first surface of the wafer 100. However, embodiments are not limited thereto. For example, the semiconductor architecture 1 may be a back side power distribution network (BSPDN) semiconductor architecture including a wafer, a first semiconductor device configured to route signals and formed on a first surface of the wafer, and a second semiconductor device configured to deliver power and formed on a second surface of the wafer opposite to the first semiconductor device.

Referring to FIG. 3, the wafer 100 includes, for example, an Si substrate, a glass substrate, a sapphire substrate, etc. However, embodiments are not limited thereto. As illustrated in FIG. 3, the wafer 100 may be a circular panel, but the shape of the wafer 100 is not limited thereto. For example, the wafer 100 may be a tetragonal panel. The wafer 100 may include a single layer or multiple layers.

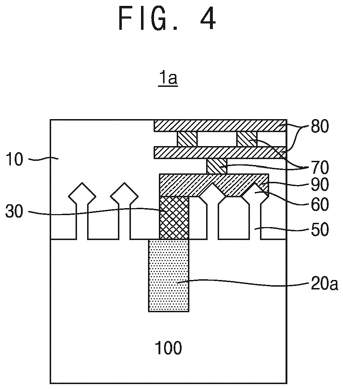

FIG. 4 illustrates a cross-sectional view taken along line I-I' of FIG. 3 according to an example embodiment.

As illustrated in FIG. 4, the semiconductor architecture 1a includes a wafer 100, fins 50 patterned on the wafer 100, and an oxide layer 10 deposited on the wafer 100. The wafer 100 and the fins 50 include, for example, Si. The fins 50 may be respective channel structures of transistors such as FinFETs, not being limited thereto. It is understood that the transistor described herebelow may be one or a combination of a FinFET, a nanowire transistor, a nanosheet transistor, etc.

The semiconductor architecture 1a also includes a semiconductor device formed on the wafer 100. The semiconductor device may be an integrated circuit configured to route signals and deliver power. The semiconductor device includes an FEOL layer including epitaxial layers 60 grown on the fins 50. The epitaxial layers 60 may form active regions, i.e., source/drain regions, of the transistors, and may include, for example, Si. The semiconductor device also includes an MOL layer including an epitaxial contact 90 that contacts the epitaxial layers 60, and extends in a horizontal direction parallel to the first surface of the wafer 100. The MOL layer may also include a vertical contact 30 that contacts the epitaxial contact 90 and penetrates the oxide layer 10 toward the first surface of the wafer 100. The semiconductor device also includes a BEOL layer including metal layers 80 configured to route signals, and vias 70 formed between the metal layers 80 to interconnect the metal layers 80. A via 70 is formed between the metal layer 80 and the epitaxial contact 90 to connect the metal layers 80 to the epitaxial layers 60.

A BPR 20a is formed to contact a surface of the vertical contact 30 and penetrate into the wafer 100 to a level below the fins 50. The BPR 20a is included inside of the wafer 100, and is configured to deliver power. A width of the BPR 20a may be greater than a width of the vertical contact 30, but embodiments are not limited thereto.

The semiconductor architecture 1a according to the example embodiment does not include any portion of the BPR capping layer shown in FIGS. 1 and 2H, and the manufacturing process may be more simplified.

The BPR 20a included in the semiconductor architecture 1a according to the example embodiment may not be thermally degraded or the thermal degradation may be reduced compared to the BPR 120 included in the semiconductor architecture 1000 according to the related art. Accordingly, degradation of the semiconductor device may be reduced or a failure of the semiconductor device may be prevented.

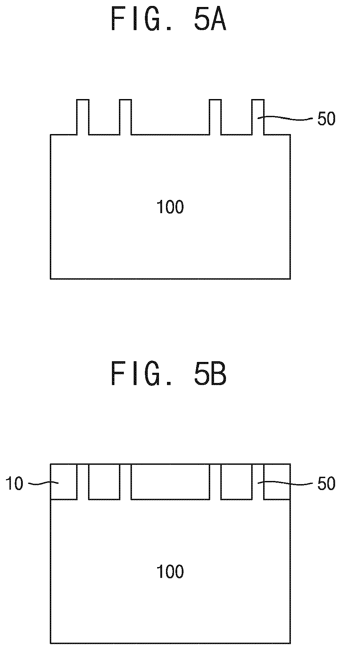

FIGS. 5A through 5H illustrate a method of manufacturing a semiconductor architecture in FIG. 4 according to an example embodiment.

As illustrated in FIG. 5A, the method includes providing a wafer 100, and patterning fins50 on the wafer 100. The wafer 100 and fins 50 include, for example, Si. Each of the fins 50 may be used as a current channel of a transistor. Although each of the fins 50 is illustrated as a fin structure of a FinFET in FIGS. 5A through 5H, the fins 50 may be a combination of multiple fin structures such as nanowires for nanowire transistor or nanosheets for a nanosheet transistor, respectively.

As illustrated in FIG. 5B, an oxide layer 10 formed of, for example, SiO, may be deposited on the wafer 100.

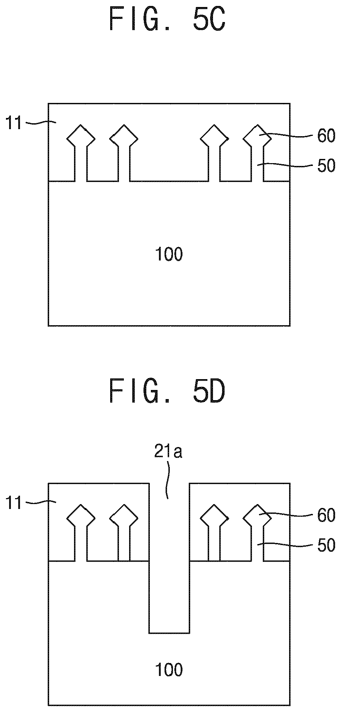

As illustrated in FIG. 5C, an FEOL layer is formed on the wafer 100. For example, epitaxial layers 60 is grown on the fins 50, and a gate structure 11 is formed on the fins 50 and the wafer 100 adjacent to the oxide layer 10. For example, FIG. 5C illustrates a cross sectional view showing the gate structure 11 formed on the fins 50. Although not illustrated in FIG. 5C, the oxide layer 10 illustrated in FIG. 5B may be provided in front of and behind the gate structure 11 in FIG. 5C. The epitaxial layers 60 may form active regions, i.e., source/drain regions, of the transistors, and may include, for example, Si.

As illustrated in FIG. 5D, a trench 21a is formed in the oxide layer 10 and the wafer 100. The trench 21a is formed to a level below the fins 50 in the wafer 100 in a vertical direction. The trench 21a is formed by, for example, various types of etching processes, not being limited thereto.

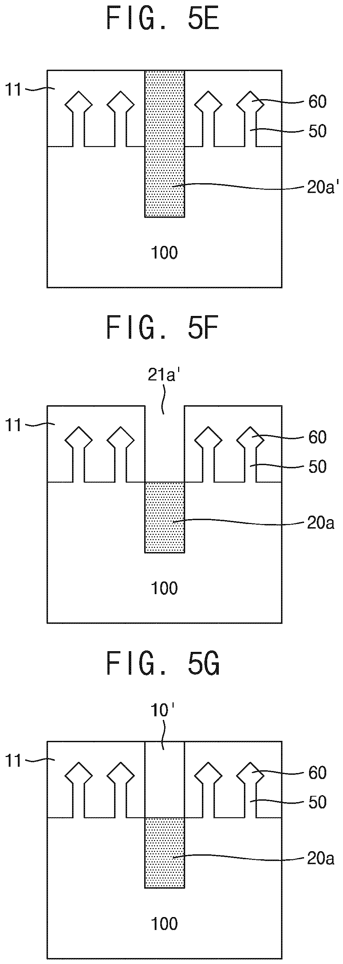

As illustrated in FIGS. 5E and 5F, a metal material 20a' such as, for example, Co, W, Ru, etc., may fill the trench 21a. A portion of the metal material 20a' is etched to a level of the first surface of the wafer 100 to form a BPR 20a and a trench 21a'. As illustrated in FIG. 5G, an oxide material 10' is filled in the trench 21a' above the BPR 20a. The oxide material 10' may be the same material forming the oxide layer 10 and may be integrally formed with the oxide layer 10.

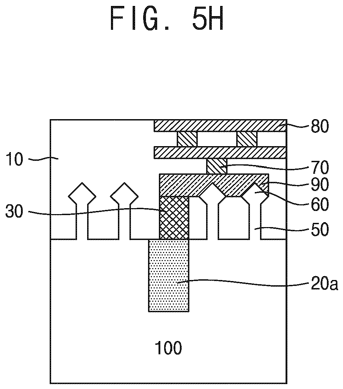

As illustrated in FIG. 5H, an MOL layer including an epitaxial contact 90 that contacts the epitaxial layer 60, and extends in a horizontal direction parallel to the first surface of the wafer 100 is formed on the FEOL layer. Forming the MOL layer also includes forming a vertical contact 30 that contacts the epitaxial contact 90 and penetrates the oxide layer 10 toward the first surface of the wafer 100 to contact an exposed surface of the BPR 20a. A BEOL layer including metal layers 80 and vias 70 are formed on the MOL layer. The vias 70 interconnect the metal layers 80, and connect the metal layer 80 to the epitaxial contact 90. Oxide material that is integrally formed with the oxide layer 10 may be adjacent to the FEOL layer, the MOL layer, and the BEOL layer to a level of the BEOL layer in a vertical direction.

According to the example embodiment, the BPR 20a included in the semiconductor architecture 1a is formed after forming the FEOL layer which requires high temperature. Accordingly, thermal degradation of the BPR 20a may be reduced or prevented, which may prevent or reduce degradation of the semiconductor device or prevent a failure of the semiconductor device.

As the method of manufacturing the semiconductor architecture 1a according to the example embodiment does not include a step of forming a BPR capping layer shown in FIGS. 1 and 2H, the manufacturing process of the semiconductor architecture 1a may be more simplified.

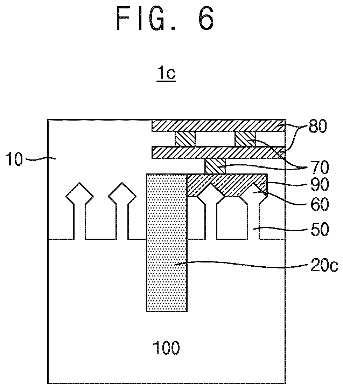

FIG. 6 illustrates a semiconductor architecture including a BPR according to another example embodiment.

According to an example embodiment, the semiconductor architecture 1c includes a wafer 100, fins 50 patterned on the wafer 100, and an oxide layer 10 deposited on the wafer 100. The wafer 100 and the fins 50 may include, for example, Si. The fins 50 may be respective channel structures of transistors such as FinFETs, not being limited thereto.

The semiconductor architecture 1c further includes a semiconductor device formed on the wafer 100. The semiconductor device may be an integrated circuit configured to route signals and deliver power. The semiconductor device includes an FEOL layer including epitaxial layers 60 grown on the fins 50. The epitaxial layers 60 may form active regions, i.e., source/drain regions, of the transistors, and may include, for example, Si. The semiconductor device also includes an MOL layer including an epitaxial contact 90 that contacts the epitaxial layer 60 and extends in a horizontal direction parallel to a first surface of the wafer 100. The semiconductor device also includes a BEOL layer including metal layers 80 configured to route signals, and a vias 70 formed between the metal layers 80 to interconnect the metal layers 80. A via 70 is also formed between the metal layer 80 and the epitaxial contact 90 to connect the epitaxial layers 60 to the metal layers 80 configured to route signals.

A BPR 20c is formed to contact the epitaxial contact 90 and penetrate into the wafer 100 to a level below the fins 50 in a vertical direction. The BPR 20c is included inside of the wafer 100, and is configured to deliver power. A width of the BPR 20c may be greater than a width of the vertical contact 30, but embodiments are not limited thereto.

The BPR 20c included in the semiconductor architecture 1c according to the example embodiment may not be thermally degraded or the thermal degradation may be reduced compared to a BPR 120 included in a semiconductor architecture 1000 according to a related art. Accordingly, degradation of the semiconductor device may be reduced or a failure of the semiconductor device may be prevented.

The semiconductor architecture 1c according to the example embodiment does not include any portion of the BPR capping layer shown in FIGS. 1 and 2H, and the manufacturing process may be more simplified. In addition, as a length of the BPR 20c in a vertical direction may be longer than the BPR 20a as illustrated in FIG. 4, a resistance of the BPR 20c may be lower than a resistance of the BPR 20a which may further improve the device performance.

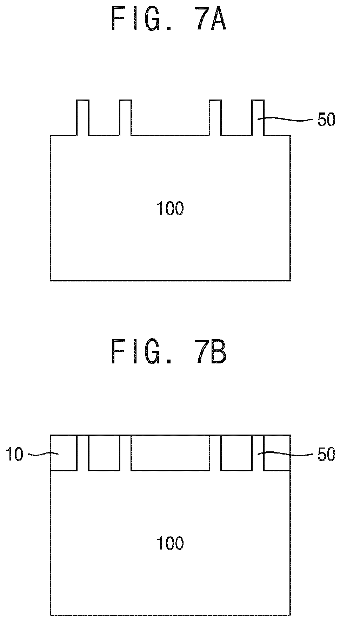

FIGS. 7A through 7F illustrate a method of manufacturing a semiconductor architecture in FIG. 6 according to an example embodiment.

As illustrated in FIG. 7A, the method includes providing a wafer 100, and patterning fins 50 on the wafer 100. The wafer 100 and fins 50 may include, for example, Si. Each of the fins 50 may be used as a current channel of a transistor. Although each of the fins 50 is illustrated as a fin structure of a FinFET in FIGS. 7A through 7F, the fin 50 may be a combination of multiple fin structures such as nanowires for a nanowire transistor or nanosheets for a nanosheet transistor, respectively.

As illustrated in FIG. 7B, an oxide layer 10 is deposited on the wafer 100.The wafer 100 and fins 50 may include, for example, Si.

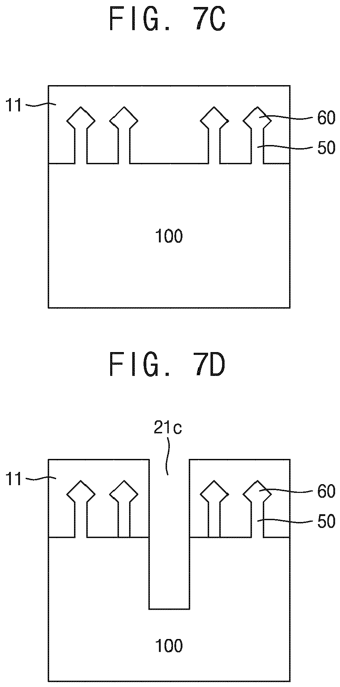

As illustrated in FIG. 7C, an FEOL layer is formed on the wafer 100. For example, epitaxial layers 60 may be grown on the fins 50, and a gate structure 11 may be formed on the wafer 100 adjacent to the oxide layer 10. The epitaxial layers 60 may form active regions, i.e., source/drain regions, of the transistors, and may include, for example Si.

As illustrated in FIG. 7D, a trench 21c is formed in the oxide layer 10 and the wafer 100. The trench 21c may be formed to a level below the fins 50 in the wafer 100 in a vertical direction. The trench 21c may be formed by, for example, dry etching or CMP. However, embodiments are not limited thereto.

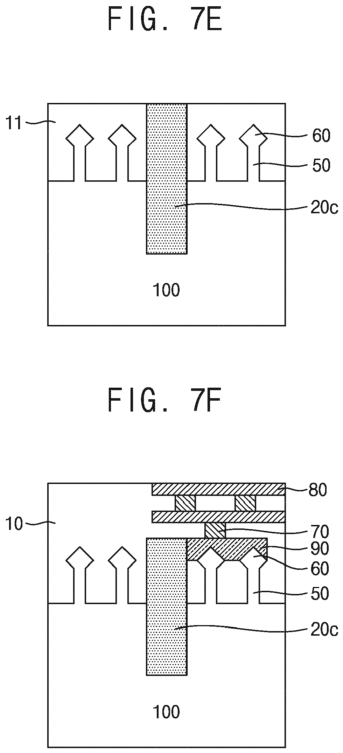

As illustrated in FIG. 7E, a metal material such as, for example, Co, W, Ru, etc., is filled in the trench 21c to form a BPR 20c.

As illustrated in FIG. 7F, an MOL layer may is formed on the FEOL layer. The MOL layer includes an epitaxial contact 90 that is formed to contact the epitaxial layers 60 and the BPR 20c. The BPR 20c extends to a level of the epitaxial contact 90 and directly contact the epitaxial contact 90.

A BEOL layer including metal layers 80 and vias 70 formed between the metal layers 80 to interconnect the metal layers 80, and a via 70 formed between the metal layer 80 and the epitaxial contact 90 is formed on the MOL layer. Oxide material that is integrally formed with the oxide layer 10 may be adjacent to the FEOL layer, the MOL layer, and the BEOL layer to a level of the BEOL layer in a vertical direction.

According to the example embodiment, the BPR 20a included in the semiconductor architecture 1c is formed after forming the FEOL layer which requires high temperature. Accordingly, the thermal degradation of the BPR 20a may be reduced or prevented which may reduce degradation of the semiconductor device or prevent a failure of the semiconductor device.

As the method of manufacturing the semiconductor architecture 1c according to the example embodiment does not include a step of forming a BPR capping layer shown in FIGS. 1 and 2H, the manufacturing process of the semiconductor architecture 1a may be more simplified. In addition, as a length of the BPR 20c in a vertical direction may be longer than the BPR 20a as illustrated in FIG. 4, a resistance of the BPR 20c may be lower than a resistance of the BPR 20a which may further improve the device performance.

As the BPR 20 directly contacts the epitaxial contact 90 and the method of manufacturing the semiconductor architecture 1c according to the example embodiment does not include forming a vertical contact between the epitaxial contact 90 and the BPR 20c, the manufacturing method may be more simplified and the resistance of the semiconductor architecture 1c may be reduced.

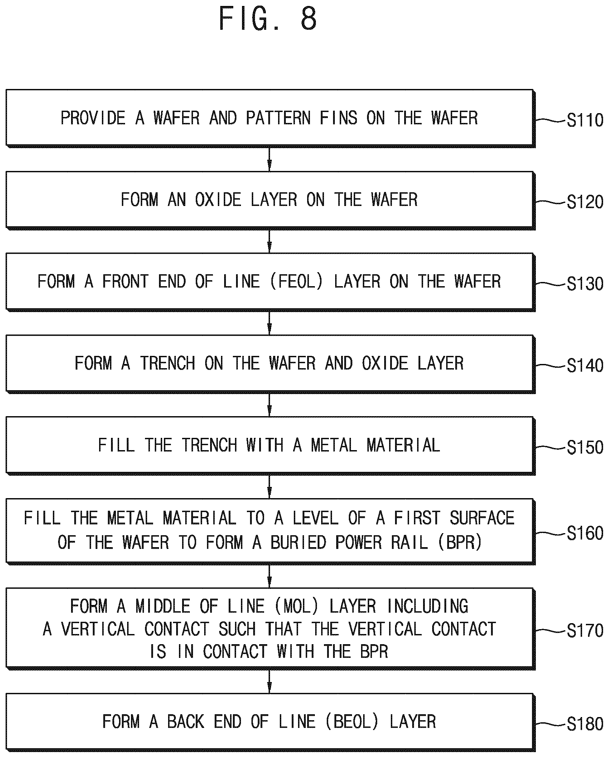

FIG. 8 illustrates a flowchart of a method of manufacturing a semiconductor architecture according to an example embodiment.

The method includes providing a wafer, and patterning fins on the wafer (S110). The wafer and fins may include, for example, Si. The fins may be channel structures of transistors such as FinFETs. An oxide layer is deposited on the wafer (S120).

An FEOL layer may be formed on the wafer (S130). For example, epitaxial layers may be grown on the fins, and a gate structure may be formed on the wafer adjacent to the oxide layer.

A trench may be formed in the wafer and the oxide layer (S140). The trench may be formed to a level below the fins in the wafer in a vertical direction. The trench may be formed by, for example, dry etching or CMP. However, embodiments are not limited thereto.

A metal material is filled in the trench (S150). The metal material may include, for example, Co, W, Ru, etc. A portion of the metal material is etched to a level of a first surface of the wafer to form a BPR (S160).

An MOL layer including a vertical contact is formed on the FEOL layer such that the vertical contact is in contact with the BPR (S170). Forming the MOL layer also includes forming an epitaxial contact that contacts the vertical contact and the epitaxial layer. A BEOL layer is formed on the MOL layer (S180). The BEOL layer includes metal layers, vias formed between the metal layers to interconnect the metal layers, and a via formed between the metal layer and the epitaxial contact.

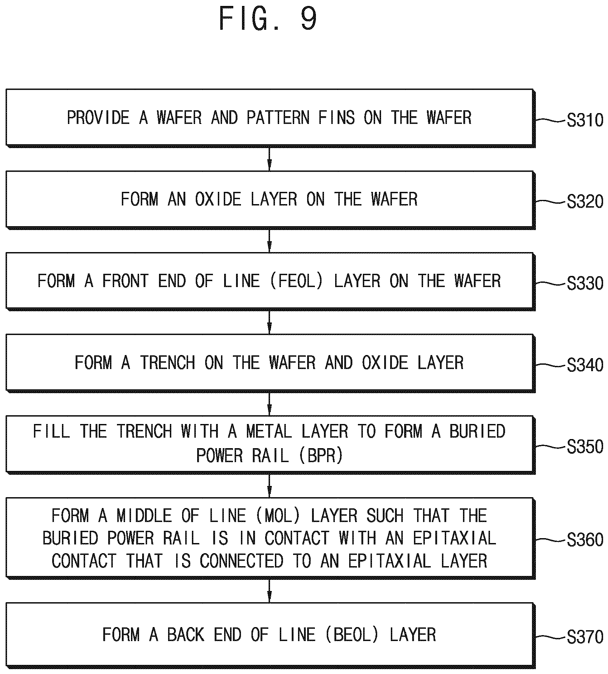

FIG. 9 illustrates a flowchart of a method of manufacturing a semiconductor architecture according to an example embodiment.

The method includes providing a wafer, and patterning fins on the wafer (S310). The wafer and fins may include, for example, Si. An oxide layer is deposited on the wafer (S320).

An FEOL layer is formed on the wafer (S330). For example, epitaxial layers may be grown on the fins, and a gate structure is formed on the wafer adjacent to the oxide layer.

A trench is formed in the oxide layer and the wafer (S340). The trench may be formed to a level below the fins in the wafer in a vertical direction. The trench may be formed by, for example, dry etching or CMP. However, embodiments are not limited thereto.

A metal material is filled in the trench to form a BPR (S350). The metal material may include, for example, Co, W, Ru, etc.

An MOL layer formed on the FEOL layer such that the BPR is in contact with an epitaxial contact (S360). The epitaxial contact is formed to contact the epitaxial layers and extend in a horizontal direction.

A BEOL layer is formed on the MOL layer (S370). The BEOL layer includes metal layers, vias formed between the metal layers to interconnect the metal layers, and a via formed between the metal layers and the epitaxial contact.

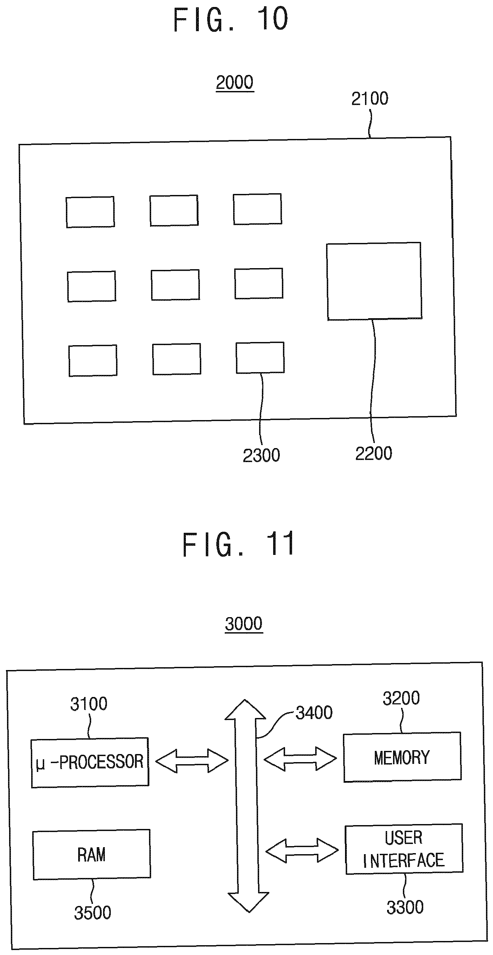

FIG. 10 illustrates a semiconductor package that may incorporate the semiconductor architecture including a BPR according to example embodiments.

Referring to FIG. 10, a semiconductor package 2000 according to an example embodiment may include a processor 2200 and semiconductor devices 2300 that are mounted on a substrate 2100. The processor 2200 and/or the semiconductor devices 2300 may include one or more of semiconductor architecture described in the above example embodiments.

FIG. 11 illustrates a schematic block diagram of an electronic system according to an example embodiment.

Referring to FIG. 11, an electronic system 3000 in accordance with an embodiment may include a microprocessor 3100, a memory 3200, and a user interface 3300 that perform data communication using a bus 3400. The microprocessor 3100 may include a central processing unit (CPU) or an application processor (AP). The electronic system 3000 may further include a random access memory (RAM) 3500 in direct communication with the microprocessor 3100. The microprocessor 3100 and/or the RAM 3500 may be implemented in a single module or package. The user interface 3300 may be used to input data to the electronic system 3000, or output data from the electronic system 3000. For example, the user interface 3300 may include a keyboard, a touch pad, a touch screen, a mouse, a scanner, a voice detector, a liquid crystal display (LCD), a micro light-emitting device (LED), an organic light-emitting diode (OLED) device, an active-matrix light-emitting diode (AMOLED) device, a printer, a lighting, or various other input/output devices without limitation. The memory 3200 may store operational codes of the microprocessor 3100, data processed by the microprocessor 3100, or data received from an external device. The memory 3200 may include a memory controller, a hard disk, or a solid state drive (SSD).

At least the microprocessor 3100, the memory 3200 and/or the RAM 3500 in the electronic system 3000 may include semiconductor architecture as described in the above example embodiments.

According to the example embodiments, a BPR included in a semiconductor architecture may be formed after forming the FEOL layer which requires high temperature. Accordingly, the thermal degradation of the BPR may be reduced or prevented which may prevent or reduce degradation of the device or a device failure, and improve the performance of a device.

It should be understood that example embodiments described herein should be considered in a descriptive sense only and not for purposes of limitation. Descriptions of features or aspects within each example embodiment should typically be considered as available for other similar features or aspects in other embodiments.

While example embodiments have been described with reference to the figures, it will be understood by those of ordinary skill in the art that various changes in form and details may be made therein without departing from the scope as defined by the following claims.

## Claims

1. A semiconductor architecture comprising:
a wafer;
a semiconductor device provided on the wafer, the semiconductor device comprising:
an epitaxial layer;
an epitaxial contact provided on the epitaxial layer;
a first via provided on the epitaxial contact; and
metal lines provided on the first via, the metal lines being configured to route signals;
an oxide layer provided on a first surface of the wafer and adjacent to the semiconductor device; and
a buried power rail, BPR, configured to deliver power, at least a portion of the BPR being inside of the wafer,
wherein a portion of the BPR contacts the oxide layer.

2. The semiconductor architecture according to claim 1, further comprising:
fins patterned on the wafer,
wherein a first end of the BPR extends in the wafer in a vertical direction to a level lower than a level of the fins.

3. The semiconductor architecture according to claim 2, further comprising:
a vertical contact provided on the epitaxial contact, the vertical contact extending to the first surface of the wafer.

4. The semiconductor architecture according to claim 3, wherein a second end of the BPR opposite to the first end of the BPR contacts the vertical contact.

5. The semiconductor architecture according to claim 2, wherein a second end of the BPR opposite to the first end of the BPR extends to a level of the epitaxial contact.

6. The semiconductor architecture according to claim 5, wherein the second end of the BPR directly contacts the epitaxial contact.

7. The semiconductor architecture according to any one of claims 2 to 6, wherein the fins are channel structures of field-effect transistors, FinFETs.

8. A method of manufacturing a semiconductor architecture, the method comprising:
providing a wafer;
patterning fins on the wafer;
providing a front-end-of-line, FEOL, layer on the wafer and the fins;
providing a trench in the wafer;
filling the trench with a metal material to form a buried power rail, BPR, configured to deliver power;
providing a middle-of-line, MOL, layer on the wafer; and
providing a back-end-of-line, BEOL, layer on the wafer.

9. The method according to claim 8, further comprising:
providing an oxide layer on the wafer and adjacent to the fins,
wherein the providing the trench comprises etching the oxide layer.

10. The method according to claim 9, wherein providing the FEOL layer comprises providing epitaxial layers on the fins, respectively.

11. The method according to claim 10, wherein providing the trench further comprises providing a first end of the trench to a level of the wafer lower than the fins in a vertical direction.

12. The method according to claim 11, further comprising:
etching the metal material filled in the trench to a level of a first surface of the wafer to form the BPR.

13. The method according to claim 12, further comprising:
filling a space formed in the trench above the BPR with an oxide material.

14. The method according to claim 13, wherein providing the MOL layer comprises:
providing an epitaxial contact on the epitaxial layers; and
providing a vertical contact that contacts the epitaxial contact and the BPR.

15. The method according to claim 14, wherein providing the BEOL layer comprises:
providing a first via on the epitaxial contact; and
providing metal layers on the first via, the metals layers being configured to route signals.
